# EUROPÄISCHE PATENTANMELDUNG

(11) **EP 0 759 658 A1**
(43) Veröffentlichungstag der Anmeldung: **26.02.1997**
(21) Anmeldenummer: 96250166.4
(22) Anmeldetag: 05.08.1996
(51) Int. Cl.: H03K 17/00, H03K 19/0175

(54) **Pegelwandler**

(30) Priorität: 10.08.1995 DE 29513492 U
(71) Anmelder: SIEMENS AKTIENGESELLSCHAFT, 80333 München (DE)
(72) Erfinder: Niewerth, Reinhard, 38122 Braunschweig (DE)

(57) **Zusammenfassung**

Die zu wandelnden Eingangssignale (E) sind den Steuereingängen eines ersten Schalters und eines invers schaltenden zweiten Schalters zugeführt. Der erste Schalter schaltet Bezugspotential (0V) und der zweite das Potential (10V), auf das die Signale umzusetzen sind. Beide Schalter können baulich vereinigt sein. Am Ausgang des Pegelwandlers stehen den Eingangssignalen (E) entsprechende Ausgangssignale (A) mit gewandeltem Pegel (10V) an.

## Beschreibung

Die Erfindung bezieht sich auf einen Pegelwandler nach dem Oberbegriff des Patentanspruches 1. Über einen solchen Pegelwandler wird u. a. in der Siemens-Zeitschrift 48 (1974), Heft 7, Seiten 499 bis 503 berichtet. Dort heißt es, daß in zunehmendem Maße für zentrale Steueraufgaben Mehrrechnersysteme verwendet werden. Die Schnittstellen der Rechner haben im allgemeinen TTL-Signalbedingungen. Diese können verschieden sein von den Signalbedingungen anderer Schaltwerke und Schaltungsteile. Damit die Rechnersysteme kommunizieren können mit diesen einem anderen Standard genügenden Schaltwerken und Schaltungsteilen, sind besondere Signalumsetzer entwickelt worden. Diese setzen z. B. TTL-Signale in gleichbedeutende Signale mit anderem Pegel um und führen sie den Schaltwerken oder Schaltungsteilen zu, die zur Verarbeitung von Signalen mit diesem Pegel ausgelegt sind. In entsprechender Weise gibt es auch Signalumsetzer für die jeweils andere Übertragungs-richtung.

Solche Einrichtungen zur Pegelumsetzung erfordern meist einen recht hohen Bauteileaufwand insbesondere auch deshalb, weil in ihnen meist noch andere Funktionen implementiert sind, die nicht immer benötigt werden. So dienen Datenaustauscheinheiten meist zusätzlich zur Entkopplung der miteinander zusammenwirkenden Einheiten, und sie koordinieren den Informationsaustausch zwischen ihnen. Dies alles macht eine solche Austauscheinheit aufwendig und teuer. Es besteht daher Bedarf nach Pegelwandlern, die nur die Aufgabe der Pegelwandlung beinhalten und durch ihren einfachen Aufbau besonders preiswert sind und zuverlässig arbeiten.

Die Erfindung löst diese Aufgabe durch die Anwendung der kennzeichnenden Merkmale des Patentanspruches 1. Eine besonders vorteilhafte Ausgestaltung des erfindungsgemäßen Pegelwandlers ist im Anspruch 2 angegeben.

Die Erfindung ist nachstehend anhand von in der Zeichnung dargestellten Ausführungsbeispielen näher erläutert. Die Zeichnung zeigt in
- Figur 1: das Grundprinzip des erfindungsgemäßen Pegelwandlers und in
- Figur 2: eine besonders vorteilhafte Ausgestaltung eines solchen Pegelwandlers.

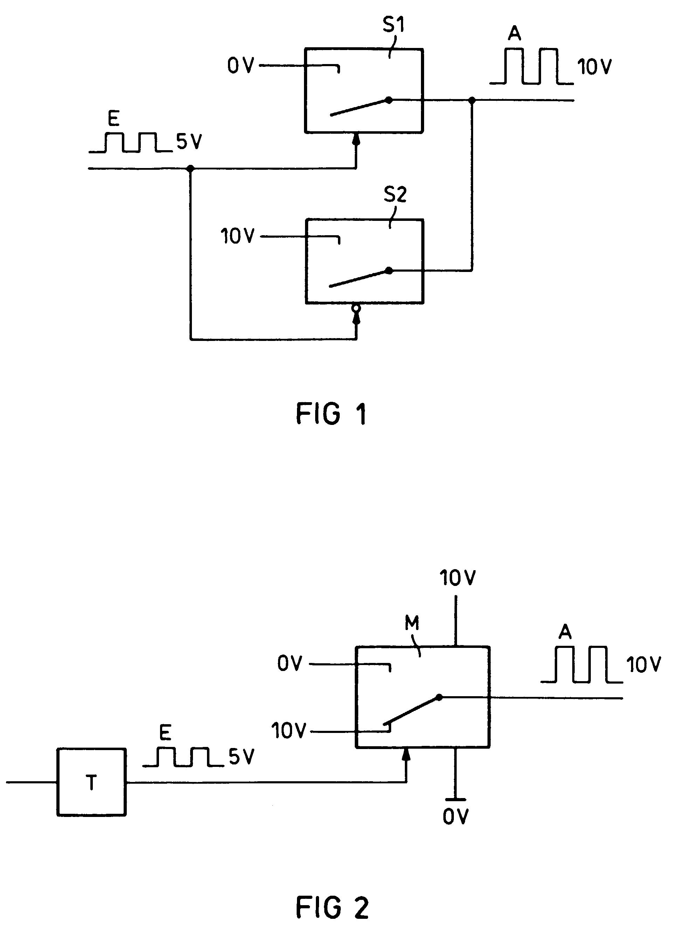

Der in Figur 1 dargestellte Pegelwandler besteht aus zwei gleichartigen Schaltern S1 und S2, von denen der eine, S1, eingangsseitig auf Bezugspotential (0-Volt) und der andere, S2, eingangsseitig auf das Potential (10-Volt) gelegt ist, auf das binäre Eingangssignale E umzusetzen sind. Die binären Eingangssignale E, die beispielsweise durch Spannungen zwischen 0 und + 5 Volt dargestellt sind, werden den Steuereingängen der beiden Schalter S1 und S2 zugeführt, wobei einer dieser Schalter, S2, einen invertierenden Steuereingang aufweist; als Alternative hierzu könnte aber auch in eine der Steuerleitungen ein externer Inverter geschaltet sein. Bei positivem Steuersignal entsprechend einem Eingangssignal der binären Wertigkeit L schließt der Schalter S1, bei Bezugspotential entsprechend einem Eingangssignal der binären Wertigkeit 0 schließt der Schalter S2. Beide Schalter sind - gegebenenfalls gegeneinander entkoppelt - ausgangsseitig zusammengeführt. An ihnen sind Ausgangssignale A abgreifbar, die inhaltlich den Eingangssignalen E entsprechen, aber in einem anderen Signalpegel als diese dargestellt sind. Mit dem erfindungsgemäßen Pegelwandler ist es möglich, den Signalpegel zwischen Ein- und Ausgangssignalen sowohl anzuheben als auch abzusenken. Die Verwendung von nur wenigen bewährten und preiswerten Schaltelementen ermöglicht den Aufbau eines zuverlässigen und preiswerten Pegelwandlers, wie er für vielfältigste Anwendungszwecke benötigt wird.

Figur 2 zeigt eine Ausgestaltung des erfindungsgemäßen Pegelwandlers, bei der die beiden Schalter einen Analog-Multiplexer M bilden. Dieser Analog-Multiplexer M liegt an einer Versorgungsspannung von z. B. 10 Volt, die vorzugsweise übereinstimmt mit dem Pegel der ausgangsseitig abzugebenden binären Signale. Die beiden Eingänge des Multiplexers liegen auf Bezugspotential (0 Volt) und auf dem Potential (10 Volt), in dem die Ausgangssignale A darzustellen sind. Die Eingangssignale E im vorgegebenen Eingangssignalpegel werden von einem TTL-Treiber T bereitgestellt. Der Multiplexer schaltet bei hohem Pegel des Eingangssignals auf seinen unteren und bei niedrigem Eingangssignalpegel auf seinen oberen Eingang und führt dabei das jeweilige Eingangspotential auf seinen Ausgang. Am Ausgang ist dann wieder eine der Eingangssignalfolge entsprechende Ausgangssignalfolge in dem jeweils gewünschten Signalpegel aufzugreifen.

Der erfindungsgemäße Pegelwandler kann bedarfsweise durch diskrete Bauelemente dargestellt sein. Es ist aber auch möglich, mehrere derartige Pegelwandler z. B. in integrierter Form räumlich benachbart z. B. auf einer Leiterplatte anzuordnen, um mit ihnen z. B. bei der parallelen Datenübertragung zwischen verschiedenen Einheiten eine parallele Datenwandlung durchzuführen.

## Patentansprüche

1. Pegelwandler zum Umsetzen von auf einem ersten Pegel liegenden digitalen Signalen in auf einem zweiten Pegel liegende digitale Signale, insbesondere als Schnittstelle zwischen in unterschiedlichen Technologien ausgeführten Bauteilen oder Teilschaltungen,
**dadurch gekennzeichnet,**
daß die zu wandelnden Signale (E) des ersten Pegels (5 Volt) mindestens mittelbar dem Steuereingang eines ersten Schalters (S1) und in invertierter Form dem Steuereingang eines zweiten Schalters oder dem invertierenden Steuereingang eines zweiten Schalters (S2) zugeführt sind,
daß der eine Schalter (S1) eingangsseitig auf Bezugspotential (0 Volt) und der andere Schalter (S2) eingangsseitig auf dem Potential des zweiten Pegels (10 Volt) liegen und daß die beiden Schalter ausgangsseitig zusammengeführt sind und an dem gemeinsamen Ausgang die gewandelten digitalen Signale (A) zur Verfügung stellen.

2. Pegelwandler nach Anspruch 1,
**dadurch gekennzeichnet,**
daß die beiden Schalter einen Analog-Multiplexer (M) bilden, dessen beide Eingänge auf Bezugspotential (0 Volt) bzw. dem Potential des zweiten Pegels (10 Volt) liegen,
dessen Steuereingang durch die digitalen Signale (E) des ersten Pegels (5 Volt) beaufschlagt ist und
dessen Ausgang die gewandelten digitalen Signale (A) zur Verfügung stellt.
